# EUROPÄISCHE PATENTSCHRIFT

(11) **EP 0 489 223 B1**
(45) Veröffentlichungstag und Bekanntmachung des Hinweises auf die Patenterteilung: **18.09.1996**
(21) Anmeldenummer: 91108409.3
(22) Anmeldetag: 24.05.1991
(51) Int. Cl.: H04B 1/66, H04N 7/26

(54) **Verfahren zur Taktratenumsetzung eines digitalisierten Signals**
Method for clock rate conversion of a digital signal
Procédé de conversion de la cadence d'horloge d'un signal numérisé

(30) Priorität: 05.12.1990 EP 90123312
(43) Veröffentlichungstag der Anmeldung: 10.06.1992
(73) Patentinhaber: Deutsche ITT Industries GmbH, D-79108 Freiburg (DE)
(72) Erfinder: Butera, Bill, W-7830 Emmendingen (DE); Alrutz, Herbert H., Dr.rer.nat., W-7806 March (DE)

(56) Entgegenhaltungen:
- 1984 INTERNATIONAL ZURICH SEMINAR ON DIGITAL COMMUNICATIONS M rz 1984, NY Seiten 7 - 13 WESTALL ET AL 'Efficient Realizations of Digital Speech Coders for Telecommunications Applications'
- PROCEEDINGS: VISUAL COMMUNICATIONS AND IMAGE PROCESSING '90 Bd. 1360, Oktober 1990, BELLINGHAM,US Seiten 765 - 776 BREEUWER ET AL 'Source Coding of HDTV with Compatability to TV'

## Beschreibung

Die Erfindung betrifft ein Verfahren zur Taktratenumsetzung eines digitalisierten Signals, wobei über die Taktratenumsetzung wesentliche Eigenschaften des Signals selbst beeinflußt werden. Die Erfindung verwendet hierbei eine Signalzerlegung in Unterbänder (= subbands). Eine Unterband-Signalverarbeitung ist beispielsweise in EP-A 413 570 für eine Bilddatenkompression geschrieben.

Als Unterbänder werden Teilsignale bezeichnet, die einzelnen Frequenzbereichen zugeordnet sind und aus dem Signal mittels einer Filterbank gewonnen werden. Mittels einer inversen Filterbank kann dann aus den einzelnen Unterbändern, die gegebenenfalls modifiziert sind, das gewünschte Ausgangssignal wieder rekonstruiert werden, das dem ursprünglichen Signal möglichst nahe kommen soll.

Die Unterbandzerlegung an sich ist aus der analogen Signalverarbeitung längst bekannt - sie wird jedoch besonders für die digitale Signalverarbeitung interessant, weil durch die Genauigkeit und Stabilität der digitalen Filter und der weiteren digitalen Signalverarbeitung keine unvorhergesehenen Störsignale entstehen, die bei der späteren Rekonstruktion oder Synthese des Ausgangssignals zu einer unzulässigen Signalverfälschung führen. Dies gilt sowohl für eindimensionale Signale, wie Audiosignale, als auch für zwei- oder mehrdimensionale Signale, wie beispielsweise Fernsehsignale mit einer mehrdimensionalen Rasterabtastung.

Die Überlagerung der horizontalen und vertikalen Abtastung der Bildpunkte eines Bildes entspricht einem Videosignal mit zwei Dimensionen. Wird die fortlaufende Bildfolge als dritte Abtastfolge berücksichtigt, dann entspricht dies einem üblichen Videosignal mit drei Dimensionen, wobei die Abtastrate der drei Dimensionen sehr unterschiedlich ist.

Aus Proceedings, "Visual Communications and Image Processing '90, " 1. bis 04. Oktober 1990, Lausanne, SPIE-Band 1360, Oktober 1990, Verlag Bellingham, US, Seiten 765 bis 776 ist unter dem Titel "Source Coding of HDTV with Compatibility to TV" von M. Breeuwer and others ein Umdodierungsverfahren von HDTV-Signalen in übliche TV-Standards beschrieben. Dabei wird das digitalisierte HDTV-Signal in horizontaler und vertikaler Richtung jeweils mittels eines digitalen Tiefpaß- und Hochpaßfilters in vier Unterbandfrequenzbereiche zerlegt, wobei die jeweilige Abtastrate durch Dezimierungsschaltungen in jedem Unterbereich nur noch ein Viertel der ursprünglichen Abtastrate beträgt. Bei geeigneten Filtern weist das TV-Bild, das aus demjenigen Unterbandbereich gebildet wird, das die tiefpaßgefilterten Bildanteile enthält, eine hohe Bildqualität auf, die mit üblichen TV-Bildern vergleichbar ist. Es wird in dem Aufsatz auch erwähnt, daß aus allen Unterbandsignalen das ursprüngliche, hoch aufgelöste HDTV-Bild wieder vollständig rekonstruierbar ist.

Die Vorteile der Taktratenumsetzung nach der Erfindung liegen zum einen im Bereich der Datenspeicherung oder Datenübertragung, insbesondere bei eindimensionalen Signalen, und zum anderen bei der Formatänderung mehrdimensionaler Signale, insbesondere bei der Anpassung von Fernsehsignalen unterschiedlicher Fernsehstandards an unterschiedliche Wiedergabeeinrichtungen, die auch noch unterschiedliche Wiedergabeformate aufweisen können. Dies schließt die Anpassung an unterschiedliche Zeilenzahlen sowie die Auf- oder Abwärtstransformation von Fernsehsignalen mit unterschiedlichem Auflösungsvermögen mit ein. Dies ist für die Kompatibilität hochauflösender Fernsehstandards von großem Nutzen.

Die Erfindung und weitere Vorteile werden nun anhand der Figuren der Zeichnung näher erläutert:
Fig. 1 und Fig. 2 zeigen schematisch an einem eindimensionalen Signal die Erzeugung von Unterbandsignalen,
Fig. 3 und Fig. 4 zeigen schematisch die Rekonstruktion eines Ausgangssignals aus einem unvollständigen Satz von Unterbandsignalen,
Fig. 5 und Fig. 6 zeigen ein Beispiel zur Rekonstruktion eines Ausgangssignals aus einem extrapolierten Satz von Unterbandsignalen,
Fig. 7 zeigt schematisch das Verfahren zur Taktratenumsetzung bei mehrdimensionalen Signalen,
Fig. 8a bis Fig. 8e zeigen schematisch wie aus einem Primärbild-Datenfeld eine Primärmatrix mit 16 Unterbandsignalen gebildet wird,
Fig. 9a bis Fig. 9e zeigt schematisch, wie aus Teilen der Primärmatrix ein Bild mit geändertem Format gebildet wird,
Fig. 10 zeigt schematisch ein Beispiel zur Formatänderung eines Bildes mittels einer extrapolierten Primärmatrix und
Fig. 11 zeigt als Schema die Anzahl der aktiven Bildzeilen einiger bekannter Wiedergabestandards.

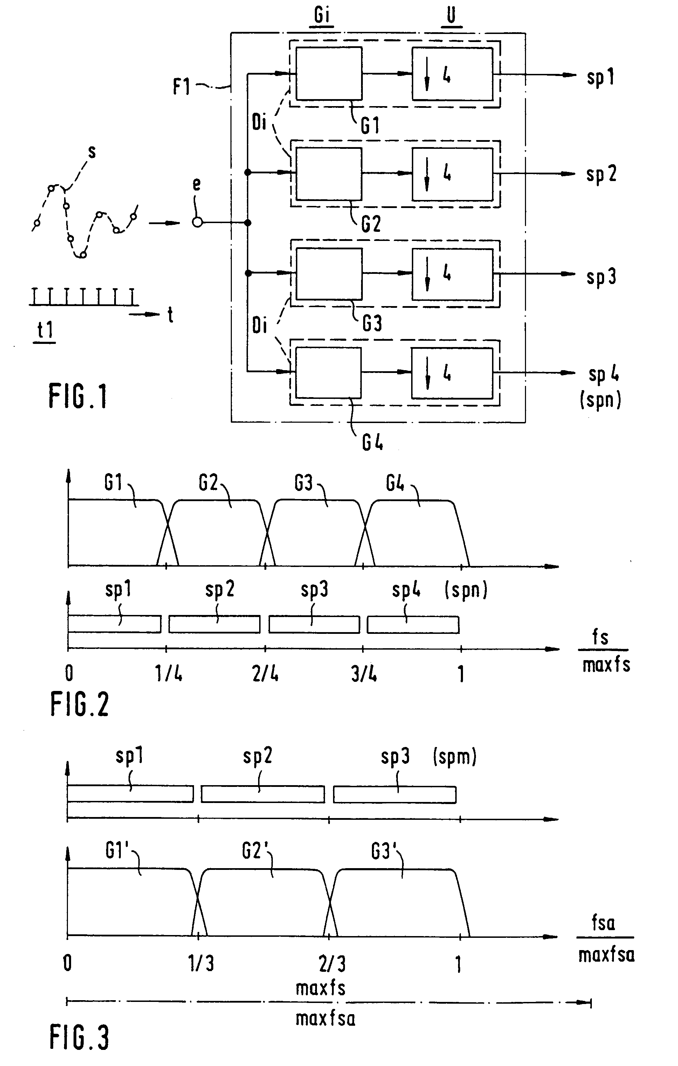

Fig. 1 zeigt im wesentlichen die erste Filtereinrichtung F1 zur Erzeugung der n primären Unterbandsignale sp1 bis spn, wobei im angegebenen Beispiel n=4 ist. Die erste Filtereinrichtung F1 bildet eine Filterbank, deren Eingangsbuchse e mit einem digitalen Signal s gespeist ist, das mit einer ersten Taktrate t1 digitalisiert ist. Die n Filterbereiche der Filterbank bestehen dabei jeweils aus einer Dezimierungseinrichtung Di mit einem Dezimationsfilter Gi und einer Unterabtaststufe U. Die Dezimationsfilter sind Bandpaßfilter, die im niedersten Frequenzbereich auch durch einen Tiefpaß ersetzt sein können. Die einzelnen Filterbereiche der Dezimationsfilter schließen sich lückenlos aneinander an und teilen den gesamten Frequenzbereich max fs des digitalen Signals s in n gleiche Frequenzabschnitte auf, vgl. Fig. 2, oberer Teil.

In der Dezimierungseinrichtung Di folgt jedem Dezimationsfilter Gi eine Unterabtaststufe U, mit der die Taktrate des gefilterten Signals um den Faktor n, im Beispiel n=4, herabgesetzt wird. Dies ist ohne Informationsverlust möglich, weil durch das Dezimationsfilter Gi die ursprüngliche Signalbandbreite um den Faktor 1/n herabgesetzt wird.

Es wird darauf hingewiesen, daß die Abtastrate der einzelnen primären Unterbandsignale sp1 bis sp4 unabhängig von deren jeweiligem Frequenzbereich fs ist, vgl. hierzu Fig. 2, unterer Teil. Eine Verletzung des Abtasttheorems, insbesondere bei dem frequenzhöchsten Unterband sp4 tritt durch die Bandbreitenbegrenzung des zugehörigen Dezimationsfilters G4 nicht ein, wobei selbstverständlich die Taktraten t1 des digitalisierten Signals s mindestens doppelt so groß wie dessen höchste Signalfrequenz max fs sein muß.

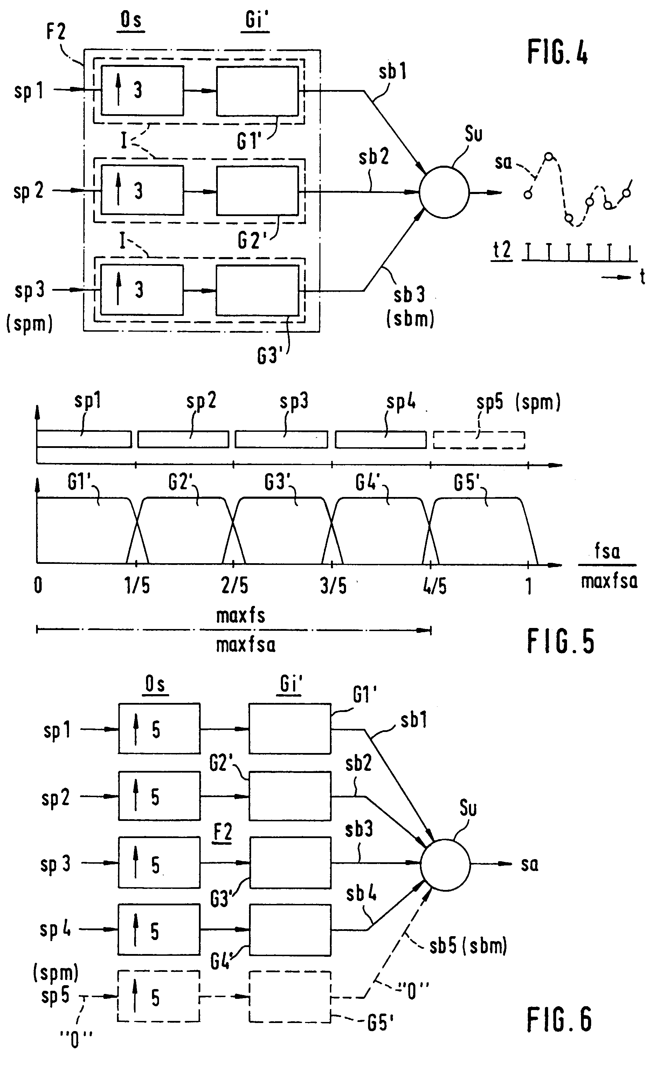

Die Zerlegung des digitalisierten Signals s in seine primäre Unterbandsignale sp1 bis spn wird auch als Analysephase bezeichnet. Ihr folgt die Synthesephase, in der aus m sekundären Unterbandsignalen sp1 bis spm mittels einer zweiten Filtereinrichtung F2 ein digitales Ausgangssignal sa mit der gewünschten Taktrate gebildet wird, vgl. Fig. 3 und Fig. 4. Dabei enthalten die m sekundären Unterbandsignale mindestens einen zusammenhängenden Teil der nach aufsteigenden Frequenzen geordneten primären Unterbandsignale der ersten Filtereinrichtung F1, den niedersten Frequenzbereich mit einschließend. In Fig. 3 und Fig. 4 ist m kleiner als n.

Wenn m größer als n ist, also im Falle nicht ausreichend vorhandener primärer Unterbandsignale sp1 bis spn, werden die nicht vorhandenen primären Unterbandsignale durch Pseudo-Unterbandsignale ersetzt; vgl. Fig. 5 und Fig. 6, in denen das nicht vorhandene Unterbandsignal sp5 gestrichelt dargestellt ist.

Fig. 3 zeigt schematisch als Frequenzschema den Fall, daß von den vier primären Unterbandsignalen der Fig. 1 und Fig. 2 lediglich die ersten drei Unterbandsignale sp1, sp2, sp3 verwendet werden. Diese drei werden jedoch auf den gesamten Frequenzbereich max fsa des Ausgangssignals sa ausgedehnt. Der Frequenzbereich max fsa wird hierzu in m = 3 gleich große Frequenzbereiche aufgeteilt, die sich aneinanderschließen. Die drei Frequenzbereiche werden durch die drei Interpolationsfilter G1', G2', G3' definiert, wobei der unterste Frequenzbereich durch ein Bandpaß- oder Tiefpaßfilter und die beiden oberen Frequenzbereiche durch jeweils ein Bandpaßfilter realisiert sind.

Fig. 4 zeigt im Blockschaltbild die zu Fig. 3 gehörige Schaltungsanordnung, und zwar die zweite Filtereinrichtung F2 und eine ihr folgende Summiereinrichtung Su, an deren Ausgang das Ausgangssignal sa mit der gewünschten zweiten Taktrate t2 abzugreifen ist. Die zweite Filtereinrichtung F2 stellt hierbei eine inverse Filterbank mit m Filterbereichen dar, die jeweils eine Interpolationseinrichtung I mit einem Interpolationsfilter Gi' und eine Überabtaststufe Os aufweisen. Die Interpolationsfilter Gi' sind als Bandpaß und/oder im niedersten Frequenzbereich als Tiefpaß ausgebildet. Mittels der Interpolationseinrichtungen I wird für jedes sekundäre Unterbandsignal eine Art Banddehnung durchgeführt, um den jeweiligen Durchlaßbereich des Interpolationsfilters Gi' auszufüllen. Zu diesem Zweck wird die Taktrate der m sekundären Unterbandsignale sp1 bis spm jeweils mittels einer dem Interpolationsfilter Gi' vorgeschalteten Überabtaststufe Os um den Faktor m wieder heraufgesetzt. Somit werden am Ausgang der zweiten Filtereinrichtung F2 m modifizierte Unterbandsignale sb1 bis sbm (im Beispiel von Fig. 4 ist m=3) gebildet, die mittels der Summiereinrichtung Su als Ausgangssignal sa mit der gewünschten Taktrate zusammengefaßt werden.

Durch die Reduzierung der Abtastrate während der Analysephase um den Faktor n und die Erhöhung der Abtastrate während der Synthesephase um den Faktor m ergibt sich insgesamt eine Abtastrate (= zweite Taktrate t2) des Ausgangssignals sa, die um den Faktor m/n von der ersten Taktrate t1 abweicht. Dabei sind m und n beliebige, aber ganzzahlige Faktoren.

In Fig. 5 und Fig. 6 ist die Synthesephase mit zugehöriger Schaltungsanordnung für den Fall m größer als n dargestellt, und zwar ausgehend von dem Analysebeispiel nach Fig. 1 und Fig. 2. In der zweiten Filtereinrichtung F2 werden m=5 sekundäre Unterbandsignale sp1 bis sp5 (= spm) verarbeitet, wobei aus der Analysephase lediglich vier primäre Unterbandsignale sp1 bis sp4 zur Verfügung stehen. Das frequenzhöchste sekundäre Unterbandsignal sp5 muß also irgendwie durch ein Pseudo-Unterbandsignal ersetzt werden. Die fünf Frequenzbereiche der zweiten Filtereinrichtung F2 sind durch die fünf Interpolationsfilter Gi' gebildet, die den gesamten Frequenzbereich max fsa des Ausgangssignals sa in fünf gleich große, sich aneinanderschließende Frequenzbereiche aufteilen, vgl. Fig. 5, mittlerer Teil.

Fig. 6 zeigt, daß jedem Interpolationsfilter Gi' eine Überabtaststufe Os vorgeschaltet ist, in der die Taktrate des jeweils zugeführten sekundären Unterbandsignals um den Faktor m (im Beispiel m=5) erhöht wird.

Der gestrichelt dargestellte fünfte Frequenzbereich der zweiten Filtereinrichtung F2 kann entfallen, wenn als Pseudo-Unterbandsignal sp5 der digitale Wert "0" zugeführt wird. Das Ausgangssignal sb5 dieses Filterbereiches hat dann ebenfalls stets den Wert "0" und tritt bei der nachfolgenden Summation der modifizierten Unterbandsignale sb1 bis sb5 nicht in Erscheinung.

Ein wichtiger Anwendungsfall der Taktratenumsetzung ergibt sich bei der Übertragung von Signalen über vorhandene Übertragungsdienste, die in der Regel Übertragungsbandbreiten aufweisen, die mit dem zu übertragenden Signal nicht übereinstimmen, also größer oder kleiner sind. Nach der Erfindung ist es möglich, daß der ursprüngliche Unterbandsatz für die Übertragung auf mehrere Übertragungsdienste aufgeteilt wird, die auf der Empfängerseite ohne Informationsverlust oder Informationsverfälschung wieder zusammengeführt werden, um das ursprüngliche Signal zu rekonstruieren. Bei unsicheren Übertragungsdiensten kann die Gesamtübertragungsqualität dadurch verbessert werden, daß über die unsicheren Übertragungsdienste möglichst nur diejenigen Unterbänder übertragen werden, die für das rekonstruierte Signal von geringerer Bedeutung sind.

Weil die Anzahl der zu synthetisierenden Unterbänder durch die Qualitätsanforderung auf der Syntheseseite bestimmt wird, ist es bei einem niederen Qualitätsniveau gar nicht erforderlich, auf der Analysenseite alle Unterbandsignale zu erzeugen oder zu übertragen. Dies ermöglicht beispielsweise eine Datenkomprimierung, die ohne störenden Einfluß auf das rekonstruierte Signal ist. Die Anwendung einer derartigen Datenkomprimierung erlaubt auch eine kompaktere Signalspeicherung. Eine weitere Anwendungsmöglichkeit der Taktratenumsetzung liegt im Bereich des digitalen Audiorundfunks, bei dem beispielsweise ein mit 48 kHz digitalisiertes Audiosignal in einen Datenstrom von 32 Unterbändern zerlegt werden kann. Dadurch kann die Kanalbandbreite des rekonstruierten Audiosignals, je nach der Qualitätsanforderung, in Stufen von 1,5 kHz eingestellt werden.

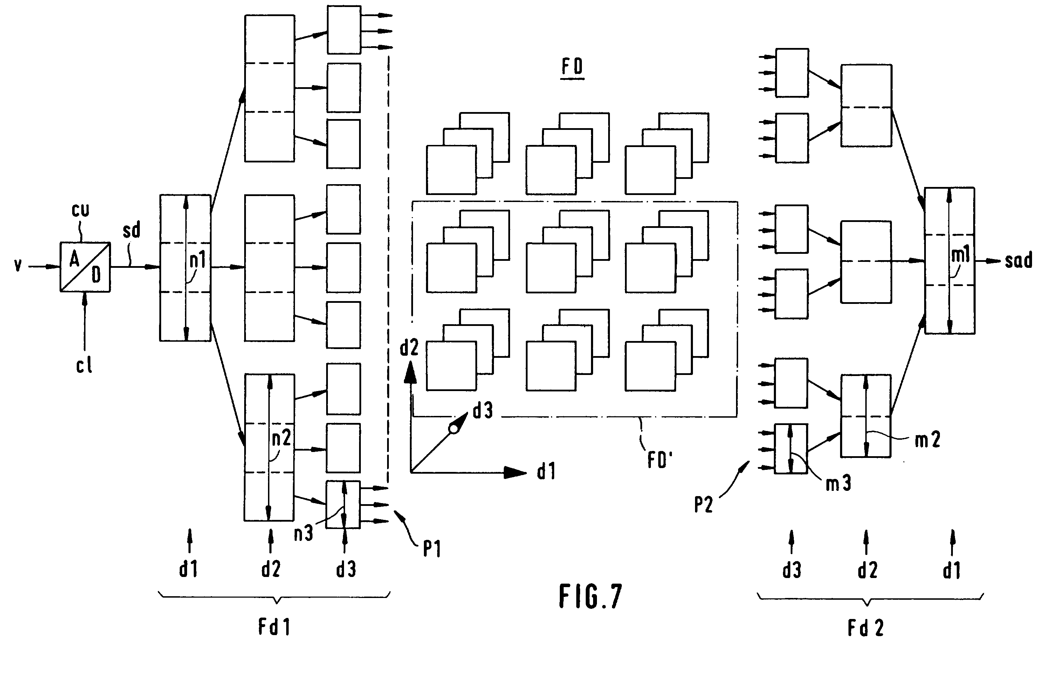

Ein weiterer, evtl. noch wichtigerer Fall der Taktratenumsetzung betrifft mehrdimensionale Signale, die wie eingangs angegeben als Videosignale einer mehrdimensionalen Rasterabtastung entstammen. Über eine Taktratenumsetzung kann dabei das Wiedergabeformat sowohl absolut, als auch relativ bezüglich des Seitenverhältnisses verändert werden. Die Taktratenumsetzung mehrdimensionaler Signale geht auf die grundsätzliche Wirkungsweise der Taktratenumsetzung bei eindimensionalen Signalen zurück - in Fig. 7 ist dies schematisch dargestellt.

In Fig. 7 ist ein analoges mehrdimensionales Signal v mittels eines Analog/Digitalumsetzers cu digitalisiert, wobei die Digitalisierungsrate durch ein Systemtakt cl bestimmt ist. Durch die Digitalisierung wird ein mehrdimensionales Digitalsignal sd gebildet, das dem Eingang einer ersten mehrdimensionalen Filtereinrichtung Fd1 zugeführt ist. In ihr erfolgt die Aufspaltung in P1 primäre Unterbandsignale, die sich nach aufsteigenden Frequenzen in Form eines mehrdimensionalen Feldes (= Unterbandmatrix) FD mit den Dimensionen di ordnen lassen. Dabei fügen sich die Frequenzbereiche der ersten mehrdimensionalen Filtereinrichtung Fd1 in Richtung jeder Dimension aneinander. Die Anzahl P1 der primären Unterbandsignale wird dabei durch das Produkt aus der Anzahl (= ni) von Frequenzbereichen bestimmt, die den einzelnen Dimensionen di zugeordnet sind. Als Zahlenbeispiel soll mit di = 3 ein dreidimensionales Signal angegeben werden, das für die Unterbandzerlegung in der Dimension d1 in n1=5 Frequenzbereiche, in der Dimension d2 in n2=4 Frequenzbereiche und in der Dimension d3 in n3=3 Frequenzbereiche aufgespalten werden soll. Dies ergibt P1 = n1 x n2 x n3 = 60 primäre Unterbandsignale, die sich in einer dreidimensionalen Matrix nach aufsteigenden Frequenzfeldern ordnen lassen.

In Fig. 7 ist schematisch eine Unterbandmatrix FD mit P1 = 27 primären Unterbandsignalen dargestellt. Die drei Dimensionen d1, d2, d3 sind dabei jeweils in drei Frequenzbereiche aufgeteilt. Die Taktrate der primären Unterbandsignale wird mittels der ersten mehrdimensionalen Filtereinrichtung Fd1 um den Faktor P1 gegenüber der ersten Taktrate (= Systemtakt cl) reduziert.

Während der Synthesephase werden P2 = 18 sekundäre Unterbandsignale der Sekundärmatrix FD' einer zweiten mehrdimensionalen Filtereinrichtung Fd2 zugeführt, deren Frequenzbereiche in den jeweiligen Dimensionen d3, d2, d1 sich aneinanderfügen. Analog zum eindimensionalen Fall wird dabei in jeder Dimension der gesamte Frequenzbereich in eine bestimmte Anzahl gleichgroßer Frequenzbereiche aufgeteilt. Als Beispiel ist in Fig. 7 für die Synthesephase angenommen, daß die Dimension d1 bzw. d2 bzw. d3 in m1 = 3 bzw. m2 = 2 bzw. m3 = 3 Frequenzbereiche aufgespalten wird. Damit wird auf der Syntheseseite das Ausgangssignal aus P2 = m1 x m2 x m3 = 18 sekundären Unterbandsignalen rekonstruiert. Die P2 Unterbandsignale enthalten dabei einen zusammenhängenden Teil der nach aufsteigenden mehrdimensionalen Frequenzfeldern geordneten primären Unterbandsignale der ersten Filtereinrichtung Fd1, und zwar vom niedersten Frequenzbereich ausgehend. Die überzähligen primären Unterbandsignale sind an der Synthese nicht beteiligt.

Im Falle nicht ausreichend vorhandener primärer Unterbandsignale, also wenn P2 größer als P1 ist, werden die nicht vorhandenen Unterbandsignale durch Pseudo-Unterbandsignale ersetzt. Im einfachsten Fall erfolgt dies durch den Wert "0", wie bereits für den eindimensionalen Fall beschrieben wurde.

Die zweite mehrdimensionale Filtereinrichtung Fd2 enthält wie die eindimensionale Anordnung für jeden Frequenzbereich eine Interpolationseinrichtung mit Interpolationsfilter und Überabtaststufe, um die Taktraten der jeweiligen Unterbandsignale um den Faktor P2 zu erhöhen. Die Taktratenumsetzung in der ersten und zweiten mehrdimensionalen Filtereinrichtung Fd1, Fd2 kann dabei jeweils in einem Schritt oder in mehreren Stufen erfolgen, dies hängt von der jeweiligen internen Organisation der mehrdimensionalen Filtereinrichtung ab. Am zweckmäßigsten ist dabei eine Kaskadierung der Filterbänke, die in Fig. 7 an einem Beispiel dargestellt ist.

Die Analyseseite zeigt in Fig. 7 eine dreistufige Kaskadierung von Filterbänken, wobei jede Stufe einer der Dimensionen d1, d2, d3, zuzurechnen ist. Die erste Filterbank für die erste Dimension d1 hat n1 unterschiedliche Frequenzbereiche. An jedem der n1 Ausgänge ist jeweils eine zweite Filterbank für die zweite Dimension d2 angeschlossen. Jede dieser zweiten Filterbänke hat n2 unterschiedliche Frequenzbereiche. An jedem dieser Ausgänge - insgesamt also n1 x n2 - ist jeweils eine dritte Filterbank für die dritte Dimension d3 mit jeweils n3 unterschiedlichen Frequenzbereichen angeschlossen. An jedem dieser Ausgänge - insgesamt also P1 = n1 x n2 x n3 - ist eines der P1 primären Unterbandsignale abgreifbar. Da die Taktrate in der ersten bzw. zweiten bzw. dritten Filterbank um den Faktor n1 bzw. n2 bzw. n3 reduziert wird, ist es unter Umständen möglich, die Anzahl der parallel arbeitenden Filterbänke durch Multiplexbetrieb drastisch zu reduzieren.

Auf der Syntheseseite ist eine entsprechende aber umgekehrte Kaskadierung zweckmäßig, wobei jeder Dimension d1, d2, d3 ein Satz inverser Filterbänke entspricht, die über Interpolationsfilter und Überabtaststufen die Taktraten wieder erhöhen. Gleichzeitig erfolgt durch die inversen Filterbänke die Summation der Einzelsignale.

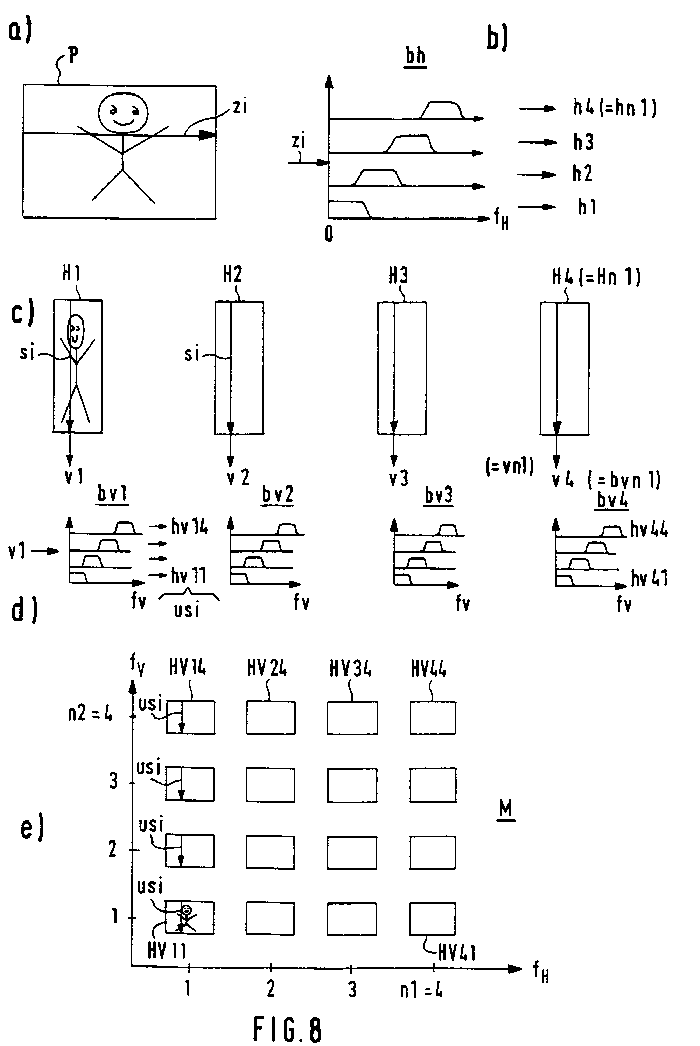

Fig. 8a zeigt ein Primärbild-Datenfeld P, das dem zeilenweise abgetasteten und digitalisierten Primärbild entspricht. Jede Datenzeile zi entspricht einer Bildzeile.

In Fig. 8b ist dargestellt, wie die Folge der einzelne Datenzeilen zi einer Horizontalfilterbank bh zugeführt sind. Der gesamte horizontale Frequenzbereich f_{H} ist im dargestellten Beispiel in vier (n1 = 4) gleich große Frequenzbereiche aufgeteilt, die sich aneinanderschließen. Der niedrigste Frequenzbereich bildet dabei einen Tiefpaß. Die vier Ausgangssignale der Horizontalfilterbank bh sind die vier h-Zeilensignale h1 bis h4 (= hn1). Das gesamte Primärbild-Datenfeld P wird somit durch die vier h-Zeilensignale in n1=4 unterschiedliche H-Datenfelder H1 bis H4 (= Hn1) zerlegt. Da für jeden Filterbereich in der Horizontalfilterbank eine Dezimierung der Primärdatenrate vorgesehen ist, beträgt der Datenumfang jedes H-Datenfeldes in horizontaler Richtung nur noch ein Viertel des ursprünglichen Datenumfangs der Datenzeile zi. Der Datenumfang in vertikaler Richtung der H-Datenfelder ist jedoch dem Primärbild-Datenfeld P gleich. In Fig. 8c ist der Datenumfang der H-Datenfelder durch die rechteckige Form schematisch dargestellt - das Strichmännchen symbolisiert die einseitige Komprimierung des Bildinhaltes.

Das Auslesen der Spalten si dieser vier H-Datenfelder H1 bis H4 erfolgt mit dem Zeilentakt des Primärbildes und liefert als Daten die n1=4 Spaltensignale v1 bis v4 (=vn1). Jedem H-Datenfeld ist eine Vertikalfilterbank bv1 bis bv4 (= bvn1) zugeordnet, die in Fig. 8d schematisch dargestellt sind. Jede der vier Vertikalfilterbänke enthält n2=4 gleich große, sich aneinanderschließende Frequenzbereiche - der gesamte vertikale Frequenzbereich f_{V} des Primärbildes wird somit in n2=4 gleich große Frequenzbereiche unterteilt. Die Ausgangssignale dieser vier Frequenzbereiche bilden die hv-Spaltensignale hv11, ..., hv44 (= hvn1n2). Die einzelnen Frequenzbereiche der Vertikalfilterbänke enthalten ebenfalls eine Dezimierungseinrichtung, so daß die Datenrate der hv-Spaltensignale im Verhältnis 1/P1 gegenüber dem ursprünglichen Zeilentakt herabgesetzt ist wobei P1 = n1 x n2 ist. Das aus jedem hv-Spaltensignal gebildete HV-Datenfeld ist in seinem Datenumfang somit gegenüber dem H-Datenfeld im Verhältnis 1/P1 reduziert. Dies ist in Fig.8e durch eine entsprechende Verkleinerung der HV-Datenfelder HV11, ..., HV44 (= HVn1n2) sowie durch das Strichmännchen schematisch dargestellt. Der Filterbereich mit der niedrigsten Durchlaßfrequenz in jeder Vertikalfilterbank ist als Tiefpaßfilter ausgebildet.

In Fig. 8e ist eine aus den einzelnen HV-Datenfeldern gebildete Primärmatrix M dargestellt, wobei die einzelnen HV-Datenfelder in horizontaler und vertikaler Richtung nach aufsteigenden horizontalen bzw. vertikalen Frequenzbereichen geordnet sind. Für das angegebene Beispiel, bei dem sowohl der horizontale Frequenzbereich f_{H} und der vertikale Frequenzbereich f_{V} jeweils in vier H Frequenzbereich unterteilt ist, ergibt sich eine Primärmatrix M aus P1 = 16 HV-Datenfeldern. Durch die doppelte Dezimierung ist der gesamte Datenumfang der Primärmatrix M gleich groß wie der Datenumfang des Primärbild-Datenfeldes P. Jedes der HV-Datenfelder repräsentiert vom gesamten Primärbild-Datenfeld P einen bestimmten Frequenzbereich in horizontaler und vertikaler Richtung. Das HV-Datenfeld HVll umfaßt dabei in horizontaler und vertikaler Richtung jeweils den niedersten Frequenzbereich mit Gleichanteil. Das HV-Datenfeld HV44 umfaßt dagegen in beiden Richtungen den höchsten Frequenzbereich.

Die Primärmatrix M enthält den gesamten, in Frequenzbereiche aufgeteilten Bildinhalt des Primärbildes. Es ist ohne weiteres einsichtig, daß die HV-Datenfelder mit hochfrequentem Frequenzanteil für die Bildwiedergabe in der Regel weniger wichtig sind als die HV-Datenfelder mit niederfrequentem Frequenzanteil.

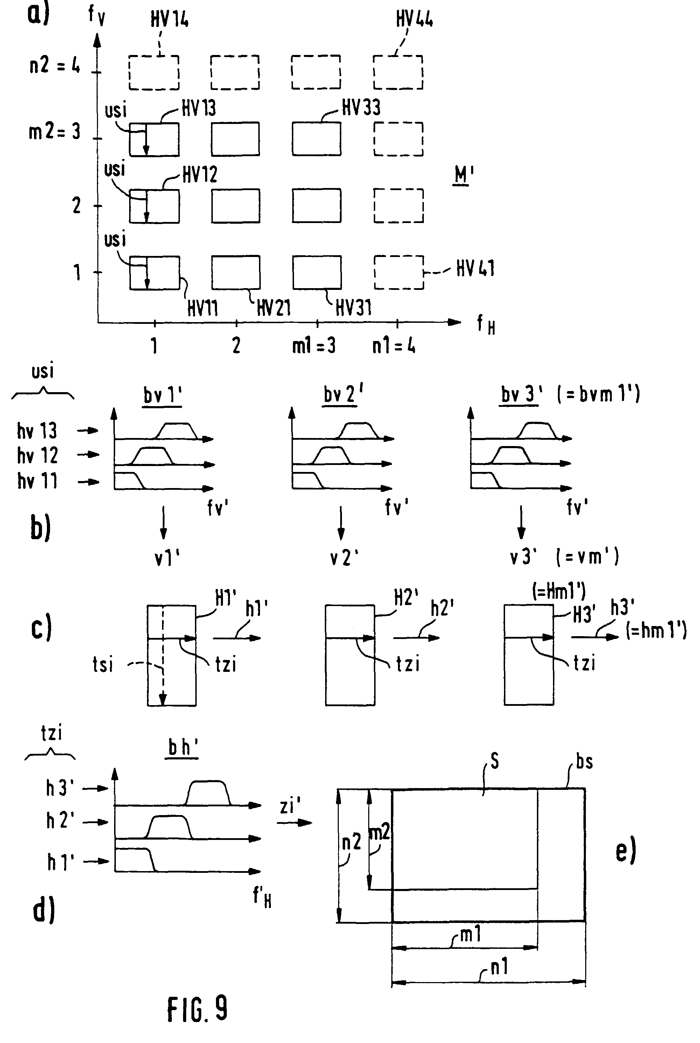

Fig. 9a zeigt eine Sekundärmatrix M', die aus der Primärmatrix M von Fig. 8e gebildet wird. Dabei werden alle sieben gestrichelt dargestellten HV-Datenfelder mit n1=4 oder n2=4 weggelassen, so daß die Sekundärmatrix M' lediglich die ursprünglichen HV-Datenfelder n1 von 1 bis 3 und n2 von 1 bis 3 umfaßt. Die hv-Spaltensignale usi dieser neun zusammengehörigen HV-Datenfelder sind m1 = 3 inversen Vertikalfilterbänken bv1', bv2', und bv3' (= bvm1') zugeführt, wobei die hv-Spaltensignale usi mit identischem horizontalen Frequenzbereich jeweils einer inversen Vertikalfilterbank zugeführt sind. Die Zuordnung der einzelnen hv-Spaltensignale zu den Eingängen der Filterbereiche erfolgt nach aufsteigenden Frequenzen.

In Fig. 9b ist schematisch dargestellt, wie aus jeweils drei hv-Spaltensignalen usi der HV-Datenfelder mittels einer inversen Vertikalfilterbank ein einziges vertikales Spaltensignal v1' bzw. v2' bzw. v3' (=vm1') gebildet wird. Jede inverse Vertikalfilterbank enthält m2 = 3 Filterbereiche, die den gesamten vertikalen Frequenzumfang f'_{V} der Sekundärbild-Wiedergabeeinrichtung bs in drei gleich große, sich aneinanderschließende Frequenzbereiche aufteilen, wobei der niederste Frequenzbereich als Tiefpaß ausgebildet ist. Die inverse Vertikalfilterbank enthält dabei ein Interpolationsfilter und eine Überabtaststufe mit dem Überabtastfaktor m2, so daß das vertikale Spaltensignal v1', v2', v3' in vertikaler Richtung in seiner Abtast- und Datenrate um den Faktor m2 = 3 größer ist als die hv-Spaltensignale usi der einzelnen HV-Datenfelder. Dies ist in Fig. 9c schematisch durch das Format und die Größe der sekundären H-Datenfelder H1', H2', H3' (= Hm1') dargestellt. Die vertikalen Spaltensignale bilden dabei die Spalten tsi der drei sekundären H-Datenfelder H1', H2', H3' (= Hm1'), die in horizontaler Richtung als Daten die Zeilen tzi bilden. Aus den Daten der Zeilen tzi werden die h-Zeilensignale h1', h2', h3' gebildet.

An die inverse Vertikalfilterung schließt sich eine inverse Horizontalfilterung an, wobei alle h-Zeilensignale h1', h2', h3' (= hm1') der drei sekundären H-Datenfelder einer inversen Horizonalfilterbank bh' zugeführt sind, vgl. Fig. 9d. Die inverse Horizontalfilterbank bh' teilt den gesamten horizontalen Frequenzbereich f'_{H} der Sekundärbild-Wiedergabeeinrichtung bs in m1 = 3 gleich große, sich aneinanderschließende Frequenzbereiche ein, wobei der niedrigste Frequenzbereich ein Tiefpaß darstellt. Das Ausgangssignal der inversen Horizontalfilterbank bh' ist ein sekundäres Zeilensignal zi'. Die Datenrate dieses Signals liegt um den Faktor m1 = 3 höher als die Datenrate der zugeführten h-Zeilensignale h1', h2', h3', denn das inverse Horizontalbankfilter enthält ein Interpolationsfilter mit einer Überabtaststufe, wobei der Überabtastfaktor m1 = 3 ist.

Aus dem sekundären Zeilensignal zi' kann nun zeilenweise das Sekundärbild-Datenfeld S aufgebaut werden, dessen Datenumfang gegenüber dem ursprünglichen Primärbild-Datenfeld P in horizontaler und in vertikaler Richtung um ein Viertel reduziert ist, vgl. Fig. 9e. Erfolgt die Bildwiedergabe mit der Primärdatenrate, dann wird das Sekundärbild-Datenfeld S in kürzerer Zeit ausgelesen und das Sekundärbild ist damit kleiner geworden. Wenn die Sekundärbild-Wiedergabeeinrichtung bs eine höhere Anzahl von Bildpunkten in horizontaler Richtung als das Primärbild aufweist, dann erscheint das Sekundärbild ebenfalls im Verhältnis n1/m1 und n2/m2 auf der Sekundärbild-Wiedergabeeinrichtung verkleinert, weil die Frequenzaufteilung in den m1 inversen Vertikalfilterbänken und in der einen inversen Horizontalfilterbank auf den gesamten Frequenzbereich f'_{H} und f'_{V} der Sekundärbild-Wiedergabeeinrichtung bezogen ist.

Eine Formatänderung eines rasterabgetasteten Bildes liegt auch vor, wenn das Videosignal ein Fernsehsignal ist, das von einem Zeilenstandard in einen anderen Zeilenstandard umgesetzt werden soll. Eine derartige Formatänderung stellt beispielsweise der Übergang von 625 Vollbildzeilen beim PAL-Zeilenstandard auf 525 Vollbildzeilen beim NTSC-Zeilenstandard dar. Dies bedeutet im Grunde genommen eine Verkleinerung des vertikalen Bildformats, die für den Betrachter dadurch kompensiert wird, daß beim NTSC-Zeilenstandard ein größerer Zeilenabstand verwendet wird - der Verlust an vertikaler Auflösung läßt sich hierdurch jedoch nicht vermeiden. Die Änderung des Zeilenstandards entspricht einer Änderung der Abtastrate in vertikaler Richtung. Dies ist die zweite Dimension des dreidimensionalen Fernsehsignals.

Eine besonders einfache Formatänderung nach der Erfindung ergibt sich bei der PAL/NTSC-Umwandlung, wenn die Primärmatrix aus 36 HV-Datenfeldern mit n1 = 6 und n2 = 6 gebildet wird und daraus eine Sekundärmatrix M' aus 30 HV-Datenfeldern mit m1 = 6 und m2 = 5 gebildet wird. Selbstverständlich werden von den 625 Vollbildzeilen nur die aktiven Bildzeilen für die Formatänderung verwendet. Die einzelnen Filterbereiche in den inversen und nichtinversen Vertikalfilterbänken sind besonders einfach als Digitalfilter zu dimensionieren, wenn der jeweilige Filterbereich auf eine ganze Zeilenanzahl bezogen werden kann. Im angegebenen Beispiel ist das ein Frequenzbereich, der jeweils 96 Zeilen entspricht und beim PAL- bzw. NTSC-Zeilenstandard 576 bzw. 480 aktive Bildzeilen ergibt, die nahezu dem tatsächlichen aktiven Bildbereich entsprechen - eventuell sind einige Leerzeilen im Primärbild einzusetzen oder einige Randzeilen wegzulassen.

Die Anzahl der Fernsehstandards wird sich in Zukunft in Richtung hochauflösender Zeilenstandards weiter vergrößern, wobei das beschriebene Verfahren auf vorteilhafte Weise den Übergang von einer Fernsehnorm auf eine andere ermöglicht. Die neuen Fernsehnormen beruhen auf einer Vollbildzeilenzahl von 1250, 1150 oder 1050. Die Kompatibilität zu den bisherigen 625- oder 525-Zeilenstandards ist nach der Erfindung herstellbar.

Die Primärmatrix M, die aus dem Videosignal nach dem 1250 Zeilenstandard gebildet wird, enthält zweckmäßigerweise 144 HV-Datenfelder, wobei n1 = 12 und n2 = 12 ist. Aus dieser Primärmatrix wird jeweils nach der gewünschten Fernseh-oder Bildwiedergabenorm eine Sekundärmatrix M' gebildet, wobei m1 und m2 für die nachfolgenden Wiedergabestandards wie folgt zu bestimmen sind - m2 ist dabei je nach der gewünschten horizontalen Auflösung vorzugeben, der Wert in der Klammer ist lediglich ein bevorzugtes Beispiel:
m1 = 6 (m2 = 6) für einen PAL-Fernsehstandard mit 625 Vollbildzeilen (entspricht 576 aktiven Bildzeilen) oder
m1 = 5 (m2 = 5) für einen NTSC-Fernsehstandard mit 525 Vollbildzeilen (entspricht 480 aktiven Bildzeilen) oder
m1 = 12 (m2 = 12) für einen Fernsehstandard mit 1250 Vollbildzeilen (entspricht 1152 aktiven Bildzeilen) oder
m1 = 11 (m2 = 11) für einen Fernsehstandard mit 1150 Vollbildzeilen (entspricht 1056 aktiven Bildzeilen) oder
m1 = 10 (m2 = 10) für einen Fernsehstandard mit 1050 Vollbildzeilen (entspricht 960 aktiven Bildzeilen) oder
m1 = 8 (m2 = 8) für einen ersten graphischen Wiedergabestandard für Rechner mit 768 aktiven Bildzeilen (= "large format VGA") oder
m1 = 5 (m2 = 5) für einen zweiten graphischen
Wiedergabestandard für Rechner mit 480 aktiven Bildzeilen (= "small format VGA").

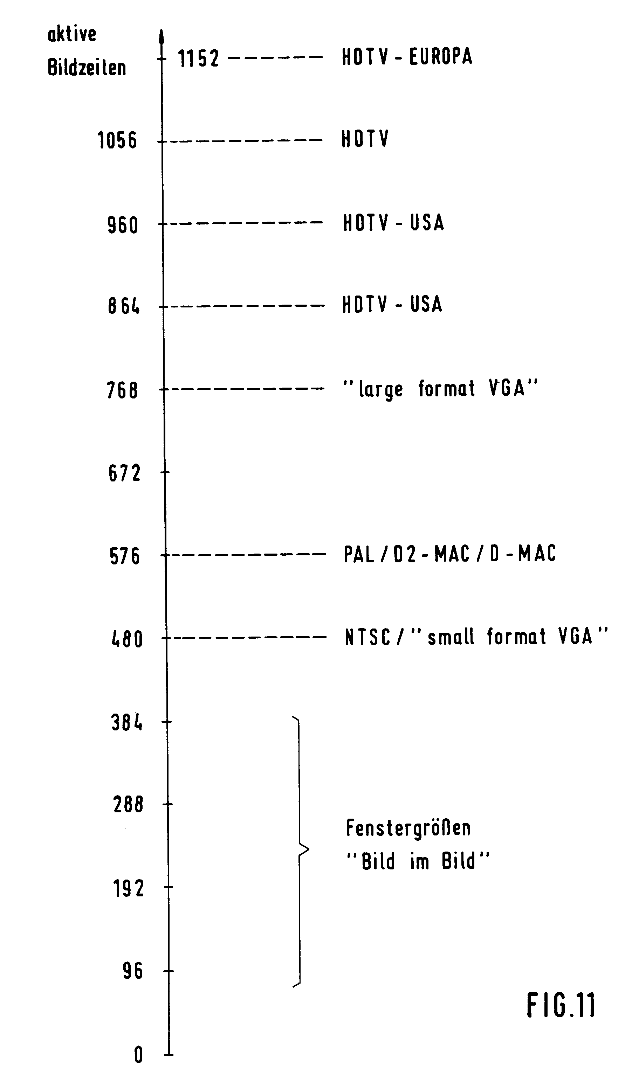

Da die graphischen Wiedergabestandards Datenverarbeitungseinrichtungen mit Vielfarbenbildschirmen betreffen, ist es möglich, daß künftig über entsprechende Transformationseinrichtungen Fernsehprogramme auch über hochauflösende Bildschirme von Datenverarbeitungsanlagen, evtl. in verkleinerter Form, eventuell auch als "Bild im Bild" mit einer bestimmten Fenstergröße auf dem Bildschirm, betrachtet werden können. Fig. 11 zeigt eine schematische Aufstellung der aktiven Bildzeilen einiger bekannter Wiedergabestandards.

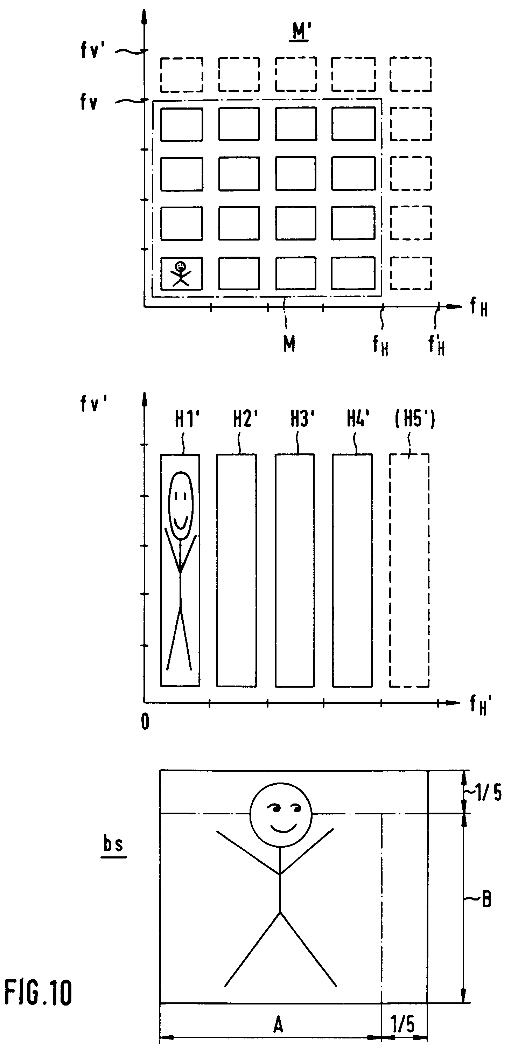

Fig. 10 zeigt anhand eines einfachen Datenfeld-Schemas die Aufwärtstransformation oder Extrapolation eines Fernsehbildes auf ein größeres Format. Die Primärmatrix M enthält nur 16 HV-Datenfelder. Die gestrichelt dargestellten 9 HV-Datenfelder mit hohem Frequenzanteil fehlen in der Sekundärmatrix M' und müssen durch 9 Pseudo-HV-Datenfelder bei der Synthese ersetzt werden. In der ersten Synthesestufe, der zu Fig. 10 gehörigen Schaltungsanordnung, die jedoch nicht dargestellt ist, sind daher nur vier erste inverse Filterbänke erforderlich. Diese fassen die in Spaltenrichtung übereinander angeordneten HV-Datenfelder der Primärmatrix M mit gleichem horizontalen Frequenzbereich zu vier sekundären H-Datenfeldern H1' bis H4' zusammen. Die ersten inversen Filterbänke teilen dabei den gesamten vertikalen Frequenzbereich f_{V}' der Sekundärbild-Wiedergabeeinrichtung bs in fünf gleiche Frequenzbereiche auf, von denen lediglich die vier frequenzniedersten mit jeweils einem primären Unterbandsignal gespeist sind. Die Ausgänge dieser vier ersten inversen Filterbänke speisen die vier frequenzniedersten vier Eingänge einer zweiten inversen Filterbank, die den gesamten horizontalen Frequenzbereich f_{H}' der Sekundärbild-Wiedergabeeinrichtung in fünf gleichgroße Frequenzbereiche einteilt. Das Ausgangssignal dieser zweiten inversen Filterbank ist das gewünschte Signal, dessen ursprüngliches Format A, B für die Sekundärbild-Wiedergabeeinrichtung bs um den Faktor 1/5 in horizontaler und vertikaler Richtung vergrößert worden ist.

## Patentansprüche

1. Verfahren zur Taktratenumsetzung eines mit einer ersten Taktrate digitalisierten Signals (s) um ein Taktratenverhältnis m/n, wobei m und n positive ganze Zahlen sind und m nicht gleich n ist,
- während einer Analysephase werden aus dem digitalen Signal (s) mittels einer ersten Filtereinrichtung (F1) n primäre Unterbandsignale (sp1..., spn) gebildet, deren jeweilige Frequenzbereiche sich aneinanderfügen und deren jeweilige Taktrate um den Faktor n geringer als die erste Taktrate (t1) ist,
- während einer Synthesephase werden m sekundäre Unterbandsignale (sp1,..., spm) einer zweiten Filtereinrichtung (F2) zugeführt, deren Frequenzbereiche sich aneinanderfügen und deren m Ausgänge m modifizierte Unterbandsignale (sb1,...sbm) liefern, wobei in der zweiten Filtereinrichtung die Taktrate um den Faktor m erhöht wird,
- während der Synthesephase werden die m modifizierten Unterbandsignale (sb1, ...sbm) mittels einer Summiereinrichtung (Su) in ein Ausgangssignal (sa) mit der gewünschten zweiten Taktrate (t2) zusammengefaßt,
- die m sekundären Unterbandsignale (sp1,...spm) enthalten mindestens eine zusammenhängende Teilmenge der nach aufsteigenden Frequenzen geordneten primären Unterbandsignale, und zwar vom niedersten Frequenzbereich ausgehend, und
- im Falle nicht ausreichend vorhandener primärer Unterbandsignale (sp1,...spn) werden die nichtvorhandenen primären Unterbandsignale durch Pseudo-Unterbandsignale ersetzt.

2. Verfahren nach Anspruch 1, gekennzeichnet durch folgende Merkmale:
- die erste Filtereinrichtung (F1) ist eine erste Filterbank mit n Filterbereichen, die jeweils eine Dezimierungseinrichtung (Di) mit einem Dezimationsfilter (Gi) und einer Unterabtaststufe (U) aufweisen,
- die Dezimationsfilter (Gi) sind Bandpaßfilter, wobei im niedersten Frequenzbereich das Bandpaßfilter durch ein Tiefpaßfilter ersetzbar ist,
- die zweite Filtereinrichtung (F2) ist eine inverse Filterbank mit m-Filterbereichen, die jeweils eine Interpolationseinrichtung (I) mit einem Interpolationsfilter (Gi') und einer Überabtaststufe (Os) aufweisen, und
- das Interpolationsfilter (Gi') ist als Bandpaß und/oder im niedersten Frequenzbereich als Tiefpaß ausgebildet.

3. Schaltungsanordnung zur Übertragung oder Speicherung eines digitalisierten Audiosignals, mit folgenden Schaltungseinrichtungen:
- eine Analyseeinrichtung bildet aus dem mit einer ersten Taktrate (t1) digitalisierten Audiosignal eine erste Anzahl n von Unterbandsignalen, deren Taktrate um den Faktor n mittels einer Dezimierungseinrichtung (Di) reduziert ist,
- einer Mehrkanalübertragungs- und/oder einer Mehrkanalspeichereinrichtung ist mindestens ein zusammenhängender Teil, einer Teilmenge, der von der Analyseeinrichtung erzeugten n Unterbandsignale zugeführt, wobei die Teilmenge mit dem niedersten Frequenzbereich beginnt, und
- eine Syntheseeinrichtung bildet aus einer zweiten Anzahl m von Unterbandsignalen, in der die Teilmenge enthalten ist, ein digitales Ausgangs-Audiosignal und erhöht in der Syntheseeinrichtung die Taktrate um den Faktor m mittels einer Interpolationseinrichtung (I), wobei m und n positive ganze Zahlen sind und m nicht gleich n ist.

4. Schaltungsanordnung nach Anspruch 3, gekennzeichnet durch folgende Merkmale:
- die Mehrkanalübertragungs- und/oder Mehrkanalspeichereinrichtung ist von der ersten Anzahl von n Unterbandsignalen in der Reihenfolge abnehmender Übertragungs- bzw. Speicherqualität belegt, und
- im Falle gestörter Unterbandsignale ist der gestörte Signalabschnitt entweder durch eine Wiederholung, eine Vorhersage oder eine Einfügung von Null-Werten ersetzt.

5. Verfahren zur Taktratenumsetzung eines mit einer ersten Taktrate digitalisierten mehrdimensionalen Signals (sd) um mindestens ein Taktratenverhältnis mi/ni, wobei das mindestens eine Taktratenverhältnis auf die zugehörige Dimension (di) bezogen ist, mᵢ und nᵢ positive ganze Zahlen sind and mᵢ nicht gleich nᵢ ist
- während einer Analysephase werden aus dem mehrdimensionalen Signal (sd) mittels einer ersten mehrdimensionalen Filtereinrichtung (Fd1) P1 (P1= n1 x ... x nd) primäre Unterbandsignale gebildet, die sich nach aufsteigenden Frequenzen in Form eines mehrdimensionalen Feldes (FD) mit den jeweiligen Dimensionen (di) ordnen lassen,
- die Frequenzbereiche der ersten mehrdimensionalen Filtereinrichtung (Fd1) fügen sich in Richtung jeder Dimension (di) aneinander,
- die Taktrate der primären Unterbandsignale wird mittels der ersten mehrdimensionalen Filtereinrichtung (Fd1) um den Faktor P1 gegenüber der ersten Taktrate (t1) reduziert,
- während einer Synthesephase werden P2 (P2= m1 x ... x md) sekundäre Unterbandsignale einer zweiten mehrdimensionalen Filtereinrichtung (Fd2) zugeführt, deren Frequenzbereiche in den jeweiligen Dimensionen (di) sich aneinanderfügen,
- die zweite mehrdimensionale Filtereinrichtung (Fd2) erzeugt aus den P2 sekundären Unterbandsignalen ein mehrdimensionales Ausgangssignal (sad) und erhöht intern die Taktrate um den Faktor P2,
- die P2 sekundären Unterbandsignale enthalten mindestens eine zusammenhängende Teilmenge der nach aufsteigenden Frequenzfeldern geordneten primären Unterbandsignale der ersten Filtereinrichtung (Fd1), und zwar vom niedersten Frequenzfeld ausgehend und
- im Falle nicht ausreichend vorhandener primärer Unterbandsignale werden die nicht vorhandenen primären Unterbandsignale durch Pseudo-Unterbandsignale ersetzt.

6. Verfahren nach Anspruch 5, gekennzeichnet durch folgende Merkmale:
- die erste mehrdimensionale Filtereinrichtung (Fd1) enthält für jede Dimension (di) mindestens eine Filterbank mit ni Filterbereichen, die jeweils eine Dezimierungseinrichtung (Di) mit einem Dezimationsfilter (Gi) und einer Unterabtaststufe (U) aufweisen,
- das Dezimationsfilter (Gi) ist als Bandpaßfilter und/oder für den niedersten Frequenzbereich als Tiefpaßfilter ausgebildet,
- die zweite mehrdimensionale Filtereinrichtung (Fd2) enthält für jede Dimension di mindestens eine inverse Filterbank mit mi Filterbereichen, die aus jeweils einem Interpolationsfilter (Gi') und einer Überabtaststufe (Os) bestehen,
- das Interpolationsfilter (Gi') ist als Bandpaß und/oder für den niedersten Frequenzbereich als Tiefpaß ausgebildet,
- die Filterbank und die inverse Filterbank teilen den gesamten Frequenzbereich der zugehörigen Dimension (di) gleichmäßig auf.

7. Verfahren zur Formatänderung eines rasterabgetasteten Bildes mittels einer Taktratenumsetzung, dessen Videosignal mit einem Systemtakt (cl) digitalisiert ist, wobei die Formatänderung in horizontaler bzw. vertikaler Richtung um den Faktor m1/n1 bzw. m2/n2 erfolgt, m₁, n₁, m₂, n₂ positive ganze Zahlen sind und wobei m₁ nicht gleich n₁ und m₂ nicht gleich n₂ ist
- ein Primärbild-Datenfeld (P) wird mittels einer einzigen Horizontalfilterbank (bh) und mittels n1 Vertikalfilterbänke (bv1, ..., bvn1) in P1 (P1 = n1 x n2) HV-Datenfelder (HV11, ..., HVn1n2) zerlegt, die nach aufsteigenden Frequenzbereichen in einer Primärmatrix (M) geordnet sind,
- die Horizontalfilterbank (bh) und die n1 Vertikalfilterbänke (bv1, ..., bvn1) teilen den jeweiligen horizontalen bzw. vertikalen Frequenzumfang (f_{H}, f_{V}) des Primärbild-Datenfeldes (P) in n1 bzw. n2 sich aneinanderschließende, gleich große Frequenzbereiche auf,
- mindestens aus einer Teilmenge der Primärmatrix (M) wird eine Sekundärmatrix (M') mit P2 (P2 = m1 x m2) HV-Datenfeldern gebildet, die in horizontaler bzw. vertikaler Richtung die HV-Datenfelder (HV11, ..., HVm1m2) von 1 bis m1 bzw. 1 bis m2 umfaßt,
- von der Sekundärmatrix (M') sind alle hv-Spaltensignale (usi) der P2 HV-Datenfelder, die dem gleichen horizontalen Frequenzbereich 1 bis m1 zugeordnet sind, jeweils einer von m1 inversen Vertikalfilterbänken (bv1', ..., bvm1) zugeführt, die den gesamten vertikalen Videofrequenzumfang (f'_{V}) einer Sekundärbild-Wiedergabeeinrichtung bs in m2 sich aneinanderschließende, gleich große Frequenzbereiche aufteilt,
- die Ausgangssignale (v1', ..., vm1') der m1 inversen Vertikalfilterbänke (bv1', ..., bvm1') bilden m1 sekundäre H-Datenfelder (H1', ..., Hm1'), die nach aufsteigenden Frequenzbereichen geordnet sind,
- die Signalverarbeitung in den m1 inversen Vertikalfilterbänken (bv1', ..., bvm1') erfolgt mit dem Zeilenfrequenztakt der Sekundärbild-Wiedergabeeinrichtung,
- von den m1 sekundären H-Datenfeldern (H1', ..., Hm1') sind die h-Zeilensignale (tzi) einer einzigen inversen Horizontalfilterbank (bh') zugeführt, die den gesamten horizontalen Videofrequenzumfang (f'_{H}) der Sekundärbild-Wiedergabeeinrichtung in ml sich aneinanderschließende, gleich große Frequenzbereiche aufteilt, wobei die Zuordnung der sekundären H-Datenfelder (H1', ..., Hm1') zu den einzelnen Frequenzbereichen der inversen Horizontalfilterbank (bh') nach aufsteigenden Frequenzen erfolgt,
- das Ausgangssignal der inversen Horizonatalfilterbank (bh') bildet ein Sekundärbild-Datenfeld (S),
- die Signalverarbeitung in der inversen Horizontalfilterbank (bh') erfolgt mit dem horizontalen Datentakt der Sekundärbild-Wiedergabeeinrichtung und
- das Sekundärbild-Datenfeld (S) ist das gesamte Datenfeld der Sekundär-Wiedergabeeinrichtung (bs).

8. Verfahren nach Anspruch 7, dadurch gekennzeichnet, daß ein Fernsehbild mit einem PAL-Zeilenstandard von 625 Vollbildzeilen in ein Fernsehbild mit einen NTSC-Zeilenstandard von 525 Vollbildzeilen umgewandelt wird, wobei:
- die Primärmatrix (M) aus P1 = 36 HV-Datenfeldern mit n1 = 6 und n2 = 6 gebildet ist und
- die Sekundärmatrix (M') aus P2 = 30 HV-Datenfeldern mit m1 = 6 und m2 = 5 gebildet ist.

9. Verfahren nach Anspruch 7, dadurch gekennzeichnet, daß bei Formatänderungsfaktoren m1/n1 und/oder m2/n2, die größer als eins sind, die ml inversen Vertikalfilterbänke (bv1', ..., bvm1) und die inverse Horizontalfilterbank (bh') anstatt mit Signalen aus den nicht vorhandenen HV-Datenfeldern m1, n1, m2 und n2 mit Datensignalen vom Wert Null gespeist sind.

10. Verfahren nach Anspruch 7, gekennzeichnet durch folgende Merkmale:
- die Primärmatrix (M) ist aus den Videodaten eines Fernsehbildes mit einem Zeilenstandard von 1250 Vollbildzeilen gebildet und enthält 144 HV-Datenfelder, wobei n1 = 12 und n2 = 12 ist,
- aus der Primärmatrix (M) wird eine Sekundärmatrix (M') gebildet, wobei m1 für die nachfolgendenen Wiedergabestandards wie folgt zu bestimmen ist:
-- m1 = 6 für ein PAL-Fernsehstandard mit 625 Vollbildzeilen oder
-- m1 = 5 für einen NTSC-Fernsehstandard mit 525 Vollbildzeilen oder
-- m1 = 12 für einen Fernsehstandard mit 1250 Vollbildzeilen oder
-- m1 = 11 für einen Fernsehstandard mit 1150 Vollbildzeilen oder
-- m1 = 10 für einen Fernsehstandard mit 1050 Vollbildzeilen oder
-- m1 = 8 für einen ersten graphischen Wiedergabestandard mit 768 aktiven Bildzeilen oder
-- m1 = 5 für einen zweiten graphischen Wiedergabestandard mit 480 aktiven Bildzeilen.

## Claims

1. A method of altering the clock rate of a signal (s) digitized at a first clock rate by a factor of m/n, where m and n are positive integers, and m is not equal to n,
- during an analysis phase, a first digital filter device (F1) transforms the digital signal (s) into n primary subband signals (sp1, ..., spn) whose respective frequency ranges adjoin each other and whose respective clock rates are lower than the first clock rate (t1) by the factor n;
- during a synthesis phase, m secondary subband signals (sp1, ..., spm) are fed to a second filter device (F2) whose frequency ranges adjoin each other and whose m outputs provide m modified subband signals (sb1, ... sbm), the clock rate being increased in the second filter device by the factor m;
- during the synthesis phase, the m modified subband signals (sb1, ...sbm) are combined by a summing device (Su) into an output signal (sa) having the desired second clock rate (t2);
- the m secondary subband signals (sp1, ...spm) contain at least one continuous subset of the primary subband signals arranged according to ascending frequencies, starting from the lowest frequency range, and
- if no sufficient primary subband signals (sp1, ..., spn) are present, the missing primary subband signals are replaced by pseudosubband signals

2. A method as claimed in claim 1, characterized by the following features:
- The first filter device (F1) is a first filter bank consisting of n filters each formed by a decimator (Di) consisting of a decimation filter (Gi) and a subsampling stage (U);
- the decimation filters (Gi) are bandpass filters, the bandpass filter for the lowest frequency range being replaceable by a low-pass filter;
- the second filter device (F2) is an inverse filter bank consisting of m filters each formed by an interpolator (I) consisting of an interpolation filter (Gi') and an oversampling stage (Os), and
- the interpolation filter (Gi') is implemented as a bandpass filter and/or, in the lowest frequency range, as a low-pass filter.

3. A circuit arrangement for transmitting or storing a digitized audio signal,
comprising the following subcircuits:
- An analysis device forms from the audio signal, digitized at a first clock rate (t1), a first number n of subband signals whose clock rate is reduced by the factor n by means of a decimator (Di);
- a multichannel transmission device and/or a multichannel storage device are/is fed with at least one continuous part, a subset, of the n subband signals generated by the analysis device, the subset beginning with the lowest frequency range, and
- a synthesis device forms a digital audio output signal from a second number m of subband signals containing the subset, and increases the clock rate by the factor m by means of an interpolator (I) contained therein, where m n are positive integers, and m is not equal to n.

4. A circuit arrangement as claimed in claim 3, characterized by the following features:
- The multichannel transmission device and/or the multichannel storage device are/is occupied by a first number n of subband signals in the order of increasing transmission and/or storage quality, respectively, and
- in case of errors occurring in subband signals, the erroneous signal section is replaced by a repetition, a prediction, or an insertion of zero values.

5. A method of altering the clock rate of a multidimensional signal (sd) digitized at a first clock rate by at least one factor mi/ni, said at least one factor being referred to the associated dimension (di),mi and ni being positive integers, and mi being not equal to ni,
- during an analysis phase, the multidimensional signal (sd) is transformed by a first multidimensional filter device (Fd1) into P1 (P1 = n1 x ... x nd) primary subband signals which can be arranged according to ascending frequencies in the form of a multidimensional array (FD) with the respective dimensions (di);
- the frequency ranges of the first multidimensional filter device (Fd1) adjoin each other in the direction of each dimension (di);
- the clock rate of the primary subband signals is reduced by the factor P1 from the first clock rate (t1) by means of the first multidimensional filter device (Fd1);
- during a synthesis phase, P2 (P2 = m1 x ... x md) secondary subband signals are fed to a second multidimensional filter device (Fd2) whose frequency ranges adjoin each other in the respective dimensions (di);
- the second multidimensional filter device (Fd2) forms a multidimensional output signal (sad) from the P2 secondary subband signals and increases internally the clock rate by the factor P2;
- the P2 secondary subband signals contain at least one continuous subset of the primary subband signals of the first filter device (Fd1) arranged according to ascending frequency fields, starting from the lowest frequency field, and
- if no sufficient primary subband signals are present, the missing primary subband signals are replaced by pseudosubband signals.

6. A method as claimed in claim 5, characterized by the following features:
- The first multidimensional filter device (Fd1) contains for each dimension (di) at least one filter bank consisting of ni filters each formed by a decimator (Di) consisting of a decimation filter (Gi) and a subsampling stage (U);
- the decimation filter (Gi) is implemented as a bandpass filter and/or, for the lowest frequency range, as a low-pass filter;
- the second multidimensional filter device (Fd2) contains for each dimension (di) at least one inverse filter bank consisting of mi filters each consisting of an interpolation filter (Gi') and an oversampling stage (Os);
- the interpolation filter (Gi') is implemented as a bandpass filter and/or, for the lowest frequency range, as a low-pass filter, and
- the filter bank and the inverse filter bank divide the total frequency range of the associated dimension (di) evenly.

7. A method for changing the format of a raster-scanned image by clock-rate conversion wherein the video signal is digitized at a system clock rate (cl), the format being changed by the factor m1/n1 in the horizontal direction and by the factor m2/n2 in the vertical direction, where m1, n1, m2, n2 are positive integers, m1 is not equal to n1, and m2 is not equal to n2,
- a primary image data field (P) is decomposed, by means of a single horizontal filter bank (bh) and n1 vertical filter banks (bv1, ..., bvn1),into P1 (P1 = n1 x n2) HV data fields (HV11, ..., HVn1n2) which are arranged according to ascending frequency ranges in a primary matrix (M);
- the horizontal filter bank (bh) divides the respective total horizontal frequency range (f_{H}) of the primary image data field (P) into n1 adjoining, equal frequency subranges, and the n1 vertical filter banks (bv1, ..., bvn1) divide the respective total vertical frequency range (f_{V}) of the primary image data field (P) into n2 adjoining, equal frequency subranges;
- at least one subset of the primary matrix (M) is transformed into a secondary matrix (M') with P2 (P2 = m1 x m2) HV data fields which contains the HV data fields (HV11, ..., HVm1m2) from 1 to m1 in the horizontal direction and from 1 to m2 in the vertical direction;
- of the secondary matrix (M'), each hv column signal (usi) of the P2 HV data fields associated with the same horizontal frequency range 1 to m1 is applied to one of m1 inverse vertical filter banks (bv1', ..., bvm1) which divides the total vertical video-frequency range (f'_{V}) of a secondary-image-reproducing device (bs) into m2 adjoining, equal frequency subranges;
- the output signals (v1', ..., vm1') from the m1 inverse vertical filter banks (bv1', ..., bvm1') form m1 secondary H data fields (H1', ..., Hm1') which are arranged according to ascending frequency subranges,
- the signal processing in the m1 inverse vertical vertical banks (bv1', ..., bvm1') takes place at the horizontal rate of the secondary-image-reproducing device;
- of the m1 secondary H data fields (H1', ..., Hm1'), the h row signals (tzi) are fed to a single inverse horizontal filter bank (bh') which divides the total horizontal video frequency range (f'_{H}) of the secondary-image-reproducing device into m1 adjoining, equal frequency subranges, the secondary H data fields (H1', ..., Hm1') being assigned to the individual frequency subranges of the inverse horizontal filter bank (bh') according to ascending frequencies;
- the output signal from the inverse horizontal filter bank (bh') forms a secondary image data field (S);
- the signal processing in the inverse horizontal filter bank (bh') takes place at the horizontal data rate of the secondary-image-reproducing device, and
- the secondary image data field (S) is the entire data field of the secondary-image-reproducing device (bs).

8. A method as claimed in claim 7, characterized in thata television picture with a PAL line standard of 625 lines per frame is converted to a television picture with an NTSC line standard of 525 lines per frame, with
- the primary matrix (M) containing P1 = 36 HV data fields with n1 = 6 and n2 = 6, and
- the secondary matrix (M') containing P2 = 30 HV data fields with m1 = 6 and m2 = 5.

9. A method as claimed in claim 7, characterized in that for format conversion factors m1/n1 and/or m2/n2 greater than unity, the m1 inverse vertical filter banks (bv1', ..., bvm1) and the inverse horizontal filter bank (bh'), instead of being supplied with signals from the HV data fields m1, n2, m2, and n2, which are not present, are fed with zero data signals.

10. A method as claimed in claim 7, characterized by the following features:
- The primary matrix (M) is formed from the video data of a television picture with a line standard of 1250 lines per frame and contains 144 HV data fields, with n1 = 12 and n2 = 12, and
- the primary matrix (M) is transformed into a secondary matrix (M'), with m1 having to be specified for the following reproduction standards as follows:
-- m1 = 6 for a PAL television standard with 625 lines per frame or
-- m1 = 5 for an NTSC television standard with 525 lines per frame or
-- m1 = 12 for a television standard with 1250 lines per frame or
-- m1 = 11 for a television standard with 1150 lines per frame or
-- m1 = 10 for a television standard with 1050 lines per frame or
-- m1 = 8 for a first graphic reproduction standard with 768 active lines or
-- m1 = 5 for a second graphic reproduction standard with 480 active lines.

## Revendications

1. Procédé pour convertir la cadence d'horloge d'un signal (s) numérisé avec une première cadence d'horloge, et ce dans un rapport de cadences d'horloge m/n, m et n étant des nombres entiers positifs et m n'étant pas égal à n, et selon lequel
- pendant une phase d'analyse, n signaux primaires de bandes partielles (sp1..., spn) sont formés à partir du signal numérique (s) au moyen d'un premier dispositif de filtre (F1), les gammes respectives de fréquences de ces signaux étant contiguës tandis que leurs cadences d'horloge respectives sont inférieures, du facteur n, à la première cadence d'horloge (t1),
- pendant une phase de synthèse, m signaux secondaires de bandes partielles (sp1..., spm), dont les gammes de fréquences sont contiguës, sont envoyés à un second dispositif de filtre (F2), dont les m sorties délivrent m signaux modifiés de bandes partielles (sb1, ... sbm), la cadence d'horloge étant accrue du facteur m dans le second dispositif de filtre,
- pendant la phase de synthèse, les m signaux modifiés de bandes partielles (sb1, ..., sbm) sont réunis, au moyen d'un dispositif de sommation (Su), en un signal de sortie (Sa) possédant la seconde cadence d'horloge désirée (t2),
- les m signaux secondaires de bandes partielles (sp1, ... spm) contiennent au moins une quantité partielle continue des signaux primaires de bandes partielles rangés selon des fréquences croissantes, et ce à partir de la gamme de fréquences la plus basse, et
- dans le cas de signaux primaires de bandes secondaires (sp1, ... spn) présents d'une manière insuffisante, les signaux primaires de bandes partielles non présents sont remplacés par des pseudo-signaux de bandes partielles.

2. Procédé selon la revendication 1, caractérisé par les caractéristiques suivantes :
- le premier dispositif de filtre (F1) est un premier bloc de filtre comportant n parties de filtre, qui possèdent chacune un dispositif de division (Di) comportant un filtre de division (Gi) et un étage de sous-échantillonnage (U),
- les filtres de division (Gi) sont des filtres passe-bande, le filtre passe-bande pouvant être remplacé, dans la gamme la plus basse de fréquences, par un filtre passe-bas,
- le second dispositif de filtre (F2) est un bloc de filtre inverse comportant m parties de filtre, qui possèdent chacune un dispositif d'interpolation (I) avec un filtre d'interpolation (Gi') et un étage de suréchantillonnage (Os), et
- le filtre d'interpolation (Gi') est agencé sous la forme d'un filtre passe-bande et/ou, dans la gamme la plus basse de fréquences, sous la forme d'un filtre passe-bas.

3. Montage pour la transmission et la mémorisation d'un signal audio mémorisé, comportant les dispositifs suivants :
- un dispositif d'analyse forme, à partir du signal audio numérisé avec une première cadence d'horloge (t1), un premier nombre n de signaux de bandes partielles, dont la cadence d'horloge est réduite, du facteur n, au moyen d'un dispositif de division (Di),
- un dispositif de transmission à canaux multiples et/ou un dispositif de mémoire à canaux multiples constituent au moins une partie continue d'une quantité partielle, à laquelle sont envoyés n signaux de bandes partielles produits par le dispositif d'analyse, la quantité partielle commençant par la gamme la plus basse de fréquences, et
- un dispositif de synthèse forme, à partir d'un second nombre m de signaux de bandes partielles, dans laquelle est contenue la quantité partielle, un signal audio numérique de sortie et, dans le dispositif de synthèse, la cadence d'horloge est accrue du facteur m au moyen d'un dispositif d'interpolation (I), m et n étant des nombres entiers positifs et n n'étant pas égal à m.

4. Montage suivant la revendication 3, caractérisé par les caractéristiques suivantes :
- le dispositif de transmission à canaux multiples et/ou le dispositif de mémoire à canaux multiples est occupé par le premier nombre n de signaux de bandes partielles dans l'ordre de qualité de transmission ou de mémorisation décroissante, et
- dans le cas de signaux de bandes partielles perturbés, la section de signal perturbée est remplacée soit par une répétition, soit par une prédiction, soit par une introduction de valeurs nulle.

5. Procédé pour convertir la cadence d'horloge d'un signal multidimensionnel (sd) numérisé avec une première cadence d'horloge, au moins dans un rapport de cadences d'horloge mi/ni, le au moins un rapport de cadences d'horloge étant rapporté à la dimension associée (di), mi et ni étant des nombres entiers positifs et mi n'étant pas égal à ni, selon lequel
- pendant une phase d'analyse, des signaux primaires de bandes partielles sont formés à partir du signal multidimensionnel (sd) au moyen d'un premier dispositif de filtre multidimensionnel (Fd1) P1 = n1 x ... x nd), signaux qui peuvent être rangés selon des fréquences croissantes, sous la forme d'un champ multidimensionnel (FD) avec les dimensions respectives (di),
- les gammes de fréquences du premier dispositif de filtre multidimensionnel (Fd1) étant contiguës dans la direction de chaque dimension (di),
- les cadences d'horloge des signaux primaires de bandes partielles sont réduites du facteur P1 par rapport à la première cadence d'horloge (t1) au moyen du premier dispositif de filtre multidimensionnel (Fd1),
- pendant une phase de synthèse, P2 (P2= m1 x ... x md) signaux secondaires de bandes partielles sont envoyés à un second dispositif de filtre multidimensionnel (Fd2), dont les gammes de fréquences sont contiguës dans les dimensions respectives (di),
- le second dispositif de filtre multidimensionnel (Fd2) produit, à partir des P2 signaux secondaires de bandes partielles, un signal de sortie multidimensionnel (sad) et augmente de façon interne la cadence d'horloge, du facteur P2,
- les P2 signaux secondaires de bandes partielles contiennent au moins une quantité partielle continue des signaux primaires de bandes partielles, rangés selon des champs de fréquences croissantes, du premier dispositif de filtre (Fd1), et ce à partir du champ de fréquences le plus bas, et
- dans le cas de signaux primaires de bandes partielles présents d'une manière insuffisante, les signaux primaires non présents de bandes partielles sont remplacés par des pseudo-signaux de bandes partielles.

6. Procédé selon la revendication 5, caractérisé par les caractéristiques suivantes :
- le premier dispositif de filtre multidimensionnel (Fd1) contient, pour chaque dimension (di), au moins un bloc de filtre comportant ni parties de filtre, qui contiennent chacune un dispositif de division (Di) équipé d'un filtre de division (Gi) et d'un étage de sous-échantillonnage (U),
- le filtre de division (Gi) est agencé sous la forme d'un filtre passe-bande et/ou, pour la gamme la plus basse de fréquences, sous la forme d'un filtre passe-bas,
- le second dispositif de filtre multidimensionnel (Fd2) contient, pour chaque dimension (di), au moins un bloc de filtre inverse comportant mi parties de filtres, qui sont constituées chacune par un filtre d'interpolation (Gi') et par un étage de suréchantillonnage (Os),
- le filtre d'interpolation (Gi') est agencé sous la forme d'un filtre passe-bande et/ou pour la gamme la plus basse de fréquences, en tant que filtre passe-bas,
- le bloc de filtre et le bloc de filtre inverse divisent de façon uniforme l'ensemble de la gamme des fréquences de la dimension associée (di).

7. Procédé pour modifier le format d'une image, explorée selon un balayage de trame, au moyen d'une conversion de cadence d'horloge dont le signal vidéo est numérisé avec une cadence d'horloge (c1) du système, la modification du format s'effectuant dans la direction horizontale ou dans la direction verticale conformément au facteur m1/n1 ou m2/n2, m1, n1, m2, n2 étant des nombres entiers positifs et m1 n'étant pas égal à n1 et m2 n'étant pas égal à n2, et selon lequel :
- un champ de données (P) de l'image primaire est subdivisé au moyen d'un seul bloc de filtre horizontal (bh) et au moyen de n1 blocs de filtre verticaux (bv1, ..., bvn1) en P1 (P1 = n1 x n2) champ de données HV (HV11, ..., HVn1n2), qui sont disposés selon des gammes croissantes de fréquences dans une matrice primaire (M),
- le bloc de filtre horizontal (bh) et les n1 blocs de filtres verticaux (bv1, ..., bvn1) divisent la gamme respective horizontale ou verticale de fréquences (f_{H}, f_{V}) du champ de données (P) de l'image primaire en n1 ou n2 gammes de fréquences, qui sont contiguës et de même grandeur,
- une matrice secondaire (M') comportant P2 (P2 = m1 x m2) champs de données HV est formée au moins à partir d'une partie de la matrice primaire (M), cette matrice englobant, dans la direction horizontale ou dans la direction verticale, des champs de données HV (HV11, ..., HVm1m2) de 1 à m1 ou de 1 à m2,
- tous les signaux de colonnes hv (usi) des P2 champs de données HV, qui sont associés à la même gamme horizontale de fréquences 1 à m1, sont envoyés par la matrice secondaire (M') respectivement à l'un de m1 blocs de filtres verticaux inverses (bv1', ..., bvm1), qui divise l'ensemble de la gamme verticale des fréquences vidéo (f'_{V}) d'un dispositif bs de reproduction d'images secondaires en m2 gammes de fréquences qui sont contiguës et possèdent une même grandeur,
- les signaux de sortie (v1', ..., vm1') des m1 blocs de filtres verticaux inverses (bv1', ..., bvm1') forment m1 champs de données H secondaires (H1', ..., Hm1'), qui sont rangés selon des gammes de fréquences croissantes,
- le traitement des signaux dans les m1 blocs de filtres verticaux inverses (bv1', ..., bvm1') s'effectue à la cadence de la fréquence de lignes du dispositif de reproduction d'images secondaires,
- les signaux de lignes h (tzi) sont envoyés par les m1 champs secondaires de données H (H1', ..., Hm1') à un seul bloc de filtre horizontal inverse (bh'), qui divise l'ensemble de la gamme des fréquences vidéo horizontales (f'_{H}) du dispositif de reproduction d'images secondaires en m1 gammes de fréquences contiguës et de même grandeur, l'association des champs secondaires de données H (H1', ..., Hm1') pour différentes gammes de fréquences du bloc de filtre horizontal inverse (bh') s'effectuant selon des fréquences croissantes,
- le signal de sortie du bloc de filtre horizontal inverse (bh') forme un champ de données (S) d'images secondaires,
- le traitement des signaux dans le bloc de filtre horizontal inverse (bh') s'effectue avec la cadence d'horloge horizontale de données du dispositif de reproduction d'images secondaires, et
- le champ de données (S) d'images secondaires est l'ensemble du champ de données du dispositif (bs) de reproduction d'images secondaires.

8. Procédé selon la revendication 7, caractérisé en ce qu'une image de télévision comportant un standard de lignes PAL comprenant 625 lignes d'image est convertie en une image de télévision comportant un standard de lignes NTSC de 525 lignes d'image, selon lequel :
- la matrice primaire (M) est formée par P1 = 36 champs de données HV avec n1 = 6 et n2 = 6, et
- la matrice secondaire (M') est formée par P2 = 30 champs de données HV avec m1 = 6 et m2 = 5.

9. Procédé selon la revendication 7, caractérisé en ce que dans le cas de facteurs de changement de format m1/n1 et/ou m2/n2, qui sont supérieurs à un, les m1 blocs de filtres verticaux inverses (bv1', ..., bvm1) et le bloc de filtre horizontal inverse (bh') sont alimentés non pas avec des signaux provenant des champs de données HV m1, n1, m2 et n2, qui ne sont pas présents, mais avec des signaux de données possédant la valeur zéro.

10. Procédé selon la revendication 7, caractérisé par les caractéristiques suivantes :
- la matrice primaire (M) est formée à partir des données vidéo d'une image de télévision comportant un standard de lignes de 1250 lignes d'image et contient 144 champs de données HV, avec n1 = 12 et n2 = 12,
- une matrice secondaire (M') est formée à partir de la matrice primaire (M), m1 devant être déterminé comme suit pour les standards suivants de reproduction :
-- m1 = 6 pour un standard de télévision PAL à 625 lignes d'image, ou
-- m1 = 5 pour un standard de télévision NTSC à 525 lignes d'image, ou
-- m1 = 12 pour un standard de télévision à 1250 lignes d'image, ou
-- m1 = 11 pour un standard de télévision à 1150 lignes d'image, ou
-- m1 = 10 pour un standard de télévision à 1050 lignes d'image, ou
-- m1 = 8 pour un premier standard graphique de reproduction avec 768 lignes d'image actives, ou
-- m1 = 5 pour un second standard graphique de reproduction avec 480 lignes actives d'image.
